Europäisches Patentamt

European Patent Office

Office européen des brevets

(11) Publication number: **0 157 974**
**B1**

(12) **EUROPEAN PATENT SPECIFICATION**

(45) Date of publication of patent specification: **06.09.89**

(21) Application number: **84303898.5**

(22) Date of filing: **08.06.84**

(51) Int. Cl.⁴: **C 30 B 31/06, C 04 B 38/06, C 04 B 32/00, C 22 C 1/08**

(54) Composite refractory foams.

(30) Priority: **08.06.83 US 502285**
**27.02.84 US 584198**

(43) Date of publication of application:
**16.10.85 Bulletin 85/42**

(45) Publication of the grant of the patent:
**06.09.89 Bulletin 89/36**

(84) Designated Contracting States:
**AT BE CH DE FR GB IT LI NL SE**

(56) References cited:
**GB-A-1 461 509**
**US-A-3 097 930**
**US-A-3 111 396**
**US-A-3 510 323**
**US-A-3 946 039**
**US-A-4 075 303**
**US-A-4 083 905**

(73) Proprietor: **STEMCOR CORPORATION**
**The Standard Oil Company Headquarters**
**Building 200 Public Square**
**Cleveland Ohio 44114-2375 (US)**

(72) Inventor: **Kasprzyk, Martin Richard**
**2648 Ransomville Road**
**Ransomville New York 14131 (US)**
Inventor: **Ten Eyck, Monika Ott**
**1458 Ridge Road**
**Lewiston New York 14092 (US)**

(74) Representative: **Fisher, Bernard et al**
**Raworth, Moss & Cook 36 Sydenham Road**
**Croydon Surrey CR0 2EF (GB)**

EP 0 157 974 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

## Description

The present invention relates generally to porous, relatively inert, and dimensionally stable, composite refractory foams which can be utilized for multiple functions including filtration, catalyst carriers and dopant carriers, and a process for the preparation of these foams.

There is a continuing need for porous relatively inert and dimensionally stable materials which can be easily formed into suitable structures for a myriad of utilities. Such materials can be used for filtration purposes, particularly in high temperature or corrosive atmospheres, for the filtration of molten metals such as aluminium or copper, as host substrates for catalysts or reactants in a chemical process, as host substrates for dopants or a diversity of other utilities. Typically, it is appropriate to form the material into a specific convenient size or shape and the ease with which the material can be so formed is an important factor to the commercial acceptability of such material.

One method of obtaining porous ceramic materials has been disclosed in the prior art, as represented by U.S.—A—3,090,094 to Schwartz-walder et al and U.S.—A—3,097,930 to Holland, wherein porous ceramic articles are prepared by immersing an open-celled porous element of pliable synthetic or natural organic material in a slurry of finely divided ceramic powder and ceramic binder, removing the excess slurry from the element and firing the material to burn away the synthetic or organic material while vitrifying the ceramic material. Amongst the various materials listed by Holland are carbides. The successful use of materials prepared in the aforesaid manner in technically exacting functions such as the filtration of molten metals, as catalyst host substrates or as dopant host substrates requires that the material possess particular physical and chemical properties such as superior permeability, structural uniformity, strength and relative inertness to chemical attack.

In the attainment of particular physical and chemical properties the prior art has taken various directions. U.S.—A—3,833,386 (Wood et al), U.S.—A—3,125,918 (McGaham et al), U.S.—A—3,345,440 (Googin et al) and U.S.—A—3,510,323 (Wismer) seek to attain superior porous materials by admixing aqueous slurry of particulate ceramic material with polymer reactants and in-situ forming a foamed polymeric/ceramic material. Thereafter, the polymeric/ceramic material is cured and subsequently heated to high temperatures to destroy the polymer, leaving a formed refractory material. Example III of the Googin et al reference discloses the preparation of a silicon carbide foam by admixing a slurry of silicon with polymer reactants to in-situ produce a foamed polyurethane/silicon material, heating to decompose the polyurethane and thereafter firing to 2200°C to react the carbon with the silicon to form in-situ silicon carbide. McGaham et al admixes silicon carbide grit with a resin binder and pore forming material to in-situ form a foamed mix which is cured and heated to carbonize the resin. Provision is also made for the addition of silicon to react with the carbonized resin to form a silicon carbide body. Though the aforesaid in-situ processes have some commercial utility, the methods require an extensive array of apparatus, with the particulate matter significantly complicating mixing and the achievement of uniform porosity.

Other prior art has taken the general direction of first forming a porous body of organic foam material, e.g., such as polyethylene, polyester, etc., then impregnating with a slurry of finely divided ceramic material, usually in aqueous suspension, then drying and firing the so obtained structure to decompose the organic foam and create a ceramic structure. U.S.—A—3,845,181; U.S.—A—3,907,579 and U.S.—A—4,004,933 (all to Ravault) describe typical procedures utilized in the treatment of various organic foams with aqueous ceramic powder containing suspensions. Therein, treated and untreated foam is impregnated with a slurry of ceramic material which is thereafter dried and fired to form the final porous ceramic article. U.S.—A—4,075,303 (Yarwood) improves on the process by utilizing a combined rolling/impregnation step to assure an appropriate final structure.

U.S.—A—3,111,396 (Ball) describes a method of making a foam material in which a porous organic structure is impregnated with a fluid suspension of powder followed by drying and heating to decompose the organic structure followed by heating to join the powder particles together. U.S.—A—4,083,905 (Insley) describes a random-fibre ceramic framework made by flocking an organic sponge, impregnating with a high alumina slurry containing a silicone resin and a flux and firing to burn out organic material to produce a vitrified foam.

One object of the invention is to provide a process for the preparation of porous refractory foam composites and to provide a composite refractory foam which is relatively inert and dimensionally stable. This and other objects will become apparent from the following description of the invention.

According to the invention there is provided a process for the preparation of a composite refractory foam which comprises impregnating a foamed organic polymeric material with a fluid slurry of a first non-oxide refractory material, drying the impregnated foamed material and heating the impregnated foamed material for a time and to a temperature sufficient to decompose the organic foamed material and leave the resulting foam devoid of organic polymeric material characterised in that, before heating, a second non-oxide refractory material is applied to the impregnated foamed inorganic polymeric material, which second refractory material has

a) a lower melting point than the first refractory material,

b) in the molten state wets the first refractory material when solid, and

c) with respect to the first refractory material has a resistance to solubility of one into the other, and the heating step is carried out at a temperature sufficient to melt the second refractory material but less than the melting point of the impregnating material so that the impregnating refractory material is infiltrated by the second refractory material.

The invention extends to a composite refractory foam devoid of organic polymeric material comprising a first non-oxide refractory material open cellularly and interconnectingly arranged and a second non-oxide refractory material having a lower melting point than the first refractory material and melt infiltrated into the first refractory material, obtainable by the process of the immediately preceding paragraph.

The process of the invention provides a composite refractory foam devoid of organic polymeric material, comprising a first particulated refractory material, open cellularly and interconnectingly arranged, having a second refractory material having a lower melting temperature than the first refractory material, melt infiltrated between at least a portion of the particles of first particulated material.

In accord with the process of the instant invention any suitable organic polymer foam material can be utilized providing it has sufficient physical properties to withstand, as desired, the process treatments prior to high temperature heating. Typical organic polymers which can be utilized in this process include cellulosics, polystyrenes, polyethylenes, polypropylenes, polyvinyl chlorides, latexes, acrylics, polyurethane foamed materials, mixtures thereof and the like. The foam may have varying degrees of rigidity or flexibility at varying temperatures. Impregnation, drying and coating with the infiltration refractory material should be instituted at controlled temperature ranges which insure that undesired breakage, dissociation or degradation of the foam will not occur during early processing steps. A foam which has adequate flexibility at temperature ranges from about 10°C to about 100°C is preferred.

The organic foam can be formed in any convenient size and shape, but generally it is formed in substantially the same size and shape as the final product which is sought to be produced. It should be recognised that before and/or during subsequent processing, the foam will be variably compressed, dried, swelled, etc., depending upon the various choice of processing alternatives hereinafter disclosed and consideration should be given thereto when sizing of the foam body for a particular purpose. One advantage of the instant invention is that the organic foam can be formed into rods, billets, etc., which thereafter can be cut into wafers, disks, etc., rather than processing each wafer, disk, etc., individually.

Typically, organic foam materials are available in a wide range of cell sizes from tightly packed small cellular configurations to large cellular configurations. Similarly, the cell density can vary greatly and typically are commercially available in multiple density gradients. We have found that for most utilities cell sizes in the range of about 2500 μm to about 50 μm (one μm=$10^{-6}$ metres) having about 10 to about 500 pores per linear inch (25.4 mm), have produced preferable results. In some instances, it has been found appropriate to compress and heat set the foam material to achieve more desirable porosity and closer size control.

To enable highly efficient production in the semiconductor industry, it is desired to use diffusion sources which are planar and thin, e.g., about 0.040±0.002 inch (1±0.05 mm) thickness. Commercially available organic polymeric foams are not at this time available in the desired thickness. Typically the thinnest commercially available organic polymeric foam which meets all of the requisite criteria is about one-eight inch (3 mm) thickness. Attempts at slicing thick foam parts to the desired gauge have not been successful. Considerable non-uniformity in thickness normally results.

In response to this problem applicants have found that organic polymeric foam meeting all the requisite criteria as well as the desired low thickness and variation in thickness can be obtained as follows. A commercially available 100 pores per lineal inch (25.4 mm), one-eighth inch (3 mm) thickness reticulated polyurethane foam sheet is compressed between two heated flat platens. One or more shims are placed between the platens to assure that the platens remain parallel and do not come closer together than the desired predetermined amount. The platens are heated to about 350—450°F (177—232°C). The organic foam is held in compression between the heated platens for about 2 to about 5 minutes during which time the organic foam takes a permanent compression set. The press is thereafter opened and the compressed-and-heat-set organic foam sheet is removed and allowed to cool. The organic foam sheet springs back somewhat upon removal from the press. Thus, the compressed gauge of the foam which corresponds to the thickness of the shims is less than the thickness of the heat set organic foam. To produce an organic foam of about 0.042±0.002 inch (1±0.05 mm) thickness, one-eighth inch (3 mm) thick 100 pores per lineal inch polyurethane foam is compressed and heat set at 0.040 inch (1 mm) platen spacing. The amount of springback and the necessary shim thickness is determined empirically.

The resulting compression set organic foam sheet contains in the direction of its planar surfaces the same number of pores per lineal inch as it had originally. Because it has been reduced in thickness, the number of pores per lineal inch in the direction of thickness has been increased inversely. For the one-eighth inch (3 mm) thickness, 100 pores per lineal inch (25.4 mm) original foam, the resulting 0.042 inch (1 mm) thick product has about 270 pores per lineal inch (25.4 mm).

The compression set organic foam is then treated as described infrax and subsequently cut into discs of three to four inches diameter utilizing a stainless steel cutting die. The second or infiltrating refractory described infrax may be applied to the particulate ceramic impregnated organic foam before die cutting into discs but is preferably applied to the discs to conserve the infiltrating refractory.

The specific times and temperatures needed to effect compression setting of a given organic polymeric foam may be determined empirically for those foams which are capable of being compression heat set.

The foam may be treated with various additives prior to, during, or after the impregnation, drying or infiltrant application processes. Typically, such additives may affect the uniform distribution of either particulate refractory material or enhance adherency to the foam material, by swelling or dissolving portions of the foamed structure to create better adhesion, or allow improved infiltration of the second refractory material. In many instances the polymer may be pre-swelled prior to treatment with the fluid slurry to increase the rate and extent of imbibition. Water itself is a suitable swelling agent for cellulosic type polymers, and in other instances aromatic alcohols, ketones or similar suitable solvents may be appropriate.

During the impregnation step of the process, particulate refractory material is deposited on the cellular organic foam, adhering to the structural elements thereof in such manner as to closely approximate the physical configuration of the foam. Upon drying, the organic foam may appear unchanged except for colour and its fragile rigidity, but upon closer inspection a thin coat of particulate refractory material can be seen deposited upon the surfaces of the cellular foam.

Typically, the refractory material containing slurry utilised for impregnation is an aqueous suspension containing from about 20 to about 80 parts by weight refractory material, generally having an average particle size of less than about 120 µm. The weight ratio of refractory material impregnated to the weight of dry foam material varies with the density of the refractory, but is generally between about 2:1 to about 12:1. Other compounds may be present such as gel formers, thickening agents or binding agents which may enhance the uniformity of distribution of the material on the foamed polymer structure during impregnation, or its infiltration, or affect its adherency thereto. Other additives may also be present such as agents which affect or in some way control drying, or agents which may have an effect upon subsequent high temperature heating of the refractory materials.

Impregnation of the foamed polymer substance can be effected by several methods. Generally, the amount of refractory deposited on the cellular structure of the polymer foam is in direct proportion to its concentration in any solution/suspension that is used for treatment. Typically, the easiest method is to immerse the polymer foam substance in a concentrated suspension of the material to be deposited. Other means of impregnation, however, include spraying means, roll coating means, or similar methods where the polymer structure is not undesirably harmed during the process. In such systems it is preferred to utilise the refractory in aqueous suspension and various additives may be present which may affect the deposition process.

Impregnation generally occurs at room temperature but the temperature thereof may be varied widely, with generally the only limitations being the deleterious effects on the organic foam being penetrated and/or fluid impregnating refractory slurry.

To improve impregnation of the foam with the fluid suspension, the impregnated foam material is typically treated to maximize the impregnation and deposition of the refractory material while expelling excess fluid suspension therefrom. Generally, this removal of fluid suspension is closely controlled and uniformly controlled throughout the foam workpiece to obtain a uniform refractory article. A wide variety of methods are known in the removal of fluid suspension from the impregnated foam, including blowing out with compressed air, centrifuging and squeezing, including passage between rollers or the like. Generally it has been found that hand squeezing is adequate, however, passing through varying roller pressures can provide a more uniform product.

After impregnation the treated organic material is dried to remove excess fluid. Drying can be achieved by any convenient means such as oven, blower, air drying, etc. Appropriate safety precautions should, however, be taken when the fluid portion of the slurry is an organic compound or contains organic compounds or the like. Generally drying temperatures should be kept low enough so that the organic foam is not detrimentally deformed or otherwise detrimentally harmed thereby. Generally, drying temperatures between from about 10°C to about 120°C are preferred for water based suspensions. It should be noted, however, that higher temperatures might in certain instances be desirable for instance to create a desirable deformation of the organic foam or to achieve a particular configuration or effect. The amount of fluid removed during the drying process can vary widely. Generally, it is preferred to dry to a fluid content less than about 50% by weight of the impregnated material.

Application of the infiltrating refractory (infiltrant) to the dried, impregnated foam can be by a fluid slurry system but generally it is preferred to apply a coarse, dry particulate coating of the infiltrating refractory to the impregnated foam. Typically it is sufficient to coat the surface of the foam with the infiltrant. Generally the weight ratio of infiltrating refractory to the dried impregnated foam is from about .05:1 to about 3:1. Particulate material, having a particle size in excess of about 20 µm, is preferred when utilizing easily oxidizable infiltrating materials as it appears to inhibit the influence of an undesirable oxide phase during the infiltration process. The thus infiltrant coated, impregnated foam body is heated to a temperature sufficient to melt the infiltrating refractory but less than that amount needed to melt the impregnated refractory. Upon heating, the organic polymer decomposes, the infiltrating refractory melts, and it is believed that through its wetting action on the impregnated refractory, the melted infiltrating refractory flows into the pores of the impregnating refractory material and the voids left by the decomposed polymer and, when solidified, forms a matrix comprising a continuous composite with the impregnated phase.

The refractory materials utilised for impregnation and infiltration can be selected from a host of non-oxide materials, though it is generally preferred that the impregnation material have a melting point which exceeds about 1400°C and the infiltration material has a melting point which exceeds about 1200°C and is below about 2300°C. The impregnating refractory material selected must have a melting point which is higher than that of the selected infiltrating material.

In addition, the melted (liquid) infiltrating refractory material should have the ability to wet the impregnating refractory material (solid) to a contact angle of less than about 45°. The contact angle is the angle between the solid surface of the impregnating material and the tangent to the liquid surface of the melted infiltrating material at the contact point of the two surfaces. In addition to the ability to wet, there should be resistance between the two materials being utilised to solubility of one into the other.

In the process of the invention, heat is applied to the refractory impregnated, refractory infiltrant coated, polymeric organic material to a temperature and time sufficient to decompose the organic foam and melt the infiltrating refractory material but less than that which will melt the impregnating refractory. The resulting rigid composite structure has substantially the same physical configuration as the foamed organic polymer, but is devoid of organic polymeric material and comprised of a composite of impregnated and infiltrated refractory materials. Varying pressures may be utilised in any step of the process, but generally it is preferred to operate at atmospheric pressure or less.

Typical refractory materials, operable as impregnating materials in accord with the instant invention, include pure elements such as tungsten, tantalum, molybdenum, niobium, chromium, zirconium, vanadium, titanium, boron, carbon, and the like; binary metal alloys such as tungsten/tantalum, tungsten/niobium, tungsten/molybdenum, tungsten/chromium, molybdenum/chromium, molybdenum/titanium, molybdenum/zirconium, and the like; borides such as $AlB_{12}$, $Ti_2B$, $TiB_2$, $ZrB_2$, $ZrB_{12}$, $HfB_2$, $Nb_3B_2$, $NbB$, $Nb_3B_4$, $NbB_2$, $Ta_2B$, $TaB$, $TaB_4$, $TaB_2$, $Cr_2B$, $Cr_5B_3$, $CrB$, $Cr_3B_4$, $CrB_2$, $CrB_4$, $Mo_2B$, $Mo_3B_2$, $MoB$, $MoB_2$, $MoB_5$, $MoB_{12}$, $W_2B$, $WB$, $W_2B_5$, $WB_{12}$. $Mn_4B$, $Mn_2B$, $MnB$, $Mn_3B_4$, $MnB_2$, $MnB_4$, $Ni_4B_3$, $NiB$, and the like; carbides such as $NbC$, $Nb_2C$, $TiC$, $ZnC$, $HfC$, $V_2C$, $VC$, $Ta_2C$, $TaC$, $Cr_{23}C_6$, $Cr_7C_3$, $Cr_3C_2$, $Mo_2C$, $MoC$, $W_2C$, $WC$, $Fe_3C$, $B_4C$, $B_{13}C_2$, $SiC$, and the like; nitrides such as $TiN$, $HfN$, $VN$, $NbN$, $TaN$, $AlN$, $BN$ and the like; phosphides such as $NbP$, $Ti_3P$, $Ti_2P$, $Cr_3P$, $BP$, $CoP_2$, and the like; silicides such as $Ti_5Si_3$, $Ti_5Si_4$, $TiSi$, $TiSi_2$, $Zr_4Si$, $Zr_2Si$, $Zr_5Si_3$, $Zr_4Si_3$, $Zr_6Si_5$, $ZrSi$, $ZrSi_2$, $Hf_2Si$, $Hf_5Si_3$, $Hf_3Si_3$, $HfSi$, $HfSi_2$, $V_3Si$, $V_5Si_3$, $V_5Si_4$, $VSi_2$, $Nb_4Si$, $Nb_5Si_3$, $NbSi_2$, $Ta_9Si_2$, $Ta_2Si_3$, $Ta_5Si$, $TaSi_2$, and the like; ternary transition metals, systems containing carbon, boron, silicon, nitrogen or combinations thereof such as Ti-Zr-C, Ti-Hf-C, Ti-V-C, Ti-Nb-C, Ti-Ta-C, Ti-Mo-B, Zr-Hf-B, Zr-Ta-B, Hf-Ta-B, V-Nb-B, Nb-Ta-Si, Nb-Mo-Si, Nb-W-Si, Tn-Mo-Si, Ta-W-Si, and the like.

Generally any of the aforedescribed impregnating materials, having melting points within the range of about 1200°C to about 2700°C, can also be utilised as infiltrating materials providing they are used in combination with an impregnating material having a higher melting point. In addition to the aforesaid, however, the infiltrating material can be a compound, mixture or pure element of silicon, cobalt, manganese, nickel and the like.

The following examples are provided to illustrate the invention and are not meant as a limitation thereof. All temperatures are in degrees Centigrade unless otherwise indicated.

Example 1

Reticulated polyurethane filter (foam material having about 20 pores per lineal inch (25.4 mm) was impregnated with a 70% aqueous alpha SiC slip having a refractory content comprising 16% submicron SiC, 24% 1000 grit (passing a sieve comprising 1000 bars per 25.4 mm) SiC and 60% 240 grit (passing a sieve comprising 240 bars per 25.4 mm) SiC. The impregnation was effected by dipping the polyurethane foam into the aqueous composition and removing excess fluids by hand squeezing. The thus impregnated material was allowed to dry overnight at room temperature until it had less than about 10% moisture content.

The top surface of the thus impregnated and dried foam material was coated with dry, powdered (500 μm), silicon to a weight ratio of silicon to impregnated foam material of 0.75:1.00. The coated, impregnated foam was decomposed and silicon infiltrated by heating, in a vacuum furnace, at 1550°C for 15 minutes. The cooled resulting product comprised a composite of particulate SiC in a matrix of silicon, substantially corresponding in porosity and form to the reticulated polyurethane foam.

Example 2

Reticulated polyurethane filter foam was impregnated with alpha SiC slip and air dried in accord with Example 1. The top surface of the resulting dried material was coated with dry, powdered (100 micron) $MoSi_2$ to a weight ratio of $MoSi_2$ to impregnated material of 0.75:1.00. The thus coated, impregnated foam was decomposed and $MoSi_2$ infiltrated by heating at 2200°C, in an argon atmosphere, for 30 minutes. The cooled resulting product comprised a composite of particulate SiC in a matrix of $MoSi_2$, substantially corresponding in porosity and form to the reticulated polyurethane foam.

Example 3

Reticulated polyurethane filter foam having a porosity of about 100 pores per inch (25.4 mm) is impregnated with a 40% aqueous suspension of 1000 grit particulate graphite and air dried in accord with the process of Example 1.

The top surface of the thus impregnated and dried foam material is coated with dry, powdered (500 µm) metallic silicon to a weight ratio of silicon to impregnated material of 2.50:1.00. The coated, impregnated foam is decomposed and silicon infiltrated by heating, in vacuum furnace, at 1525°C for 15 minutes. The resulting product comprises a composite of a continuous SiC phase and minor discontinuous silicon phase, substantially corresponding in porosity and form to the reticulated polyurethane foam.

Example 4

Reticulated polyurethane filter foam having a porosity of about 100 pores per inch (25.4 mm) is impregnated with a 70% aqueous suspension of 1000 grit $B_4C$ powder, dried, coated with metallic silicon and heated in accord with Example 1. ·

The resulting product comprises a composite of particulate $B_4C$ in a silicon matrix, substantially corresponding in porosity and form to the reticulated polyurethane foam.

Example 5

Reticulated polyurethane foam containing approximately 80 pores per inch (25.4 mm) is impregnated with a 50% aqueous suspension of 1000 grit particulate graphite, hand squeezed and air dried in accord with Example 1. The foam is coated with plus 100 mesh (149 µm)/minus 60 mesh (250 µm) boron in a weight ratio to impregnated foam of 1.0:1.0. The thus impregnated and coated foam is decomposed and boron infiltrated by heating at 2,400°C for 30 minutes, in an argon atmosphere.

The resulting product comprises a composite of $B_4C$ and boron, substantially corresponding in porosity and form to the reticulated polyurethane foam.

Example 6

Reticulated polyurethane foam containing approximately 60 pores per inch is impregnated with a 50% aqueous suspension of 1000 grit particulate graphite, hand squeezed and air dried in accord with Example 1. The foam is coated with minimum 100 mesh (149 µm) titanium in a weight ratio to impregnated foam of 3.0:1.0. The thus impregnated and coated foam is carbonised and titanium infiltrated by heating at 1850°C, for 30 minutes, in an argon atmosphere.

The resulting product comprises a composite of TiC in a titanium matrix, substantially corresponding in porosity and form to the reticulated polyurethane foam.

Example 7

Reticulated polyurethane foam containing approximately 100 pores per inch (25.4 mm) is impregnated with a 60% aqueous suspension of 1000 grit particulate boron, hand squeezed and air dried in accord with Example 1. The foam is coated with minus 60 mesh (250 µm) metallic silicon in a weight ratio is impregnated foam of 1.0:1.0. The thus impregnated and coated foam is then heated, in a vacuum furnace at 1,650°C for 30 minutes.

The resulting product comprises a composite of $B_6Si$ in silicon, substantially corresponding in porosity and form to the reticulated polyurethane foam.

**Claims**

1. A process for the preparation of a composite refractory foam which comprises impregnating a foamed organic polymeric material with a fluid slurry of a first non-oxide refractory material, drying the impregnated foamed material and heating the impregnated foamed material for a time and to a temperature sufficient to decompose the organic foamed material and leave the resulting foam devoid of organic polymeric material characterised in that, before heating, a second non-oxide refractory material is applied to the impregnated foamed inorganic polymeric material, which second refractory material has

a) a lower melting point than the first refractory material,

b) in the molten state wets the first refractory material when solid, and

c) with respect to the first refractory material has a resistance to solubility of one into the other,

and the heating step is carried out at a temperature sufficient to melt the second refractory material but less than the melting point of the impregnating material so that the impregnating refractory material is infiltrated by the second refractory material.

2. A process according to claim 1 characterised in that the foamed organic material is compressed prior to impregnation.

3. A process according to claim 1 or 2 characterised in that the foamed organic material is heat compression set to a predetermined thickness prior to impregnation.

4. A process according to claim 1, 2 or 3 characterised in that the molten second refractory material wets the solid impregnating refractory material to a contact angle of less than about 45 degrees.

5. A process according to any one of claims 1 to 4 characterised in that the impregnated foamed organic material is treated to expel fluids prior to drying.

6. A process according to claim 5 characterised in that said material is treated to expel fluids by squeezing or rolling.

7. A process according to any one of claims 1 to 6 characterised in that the heating step is carried out at a temperature from 1200°C to 2300°C.

8. A process according to any one of claims 1 to 7 characterised in that the cell size of the foamed organic material is from 2500 μm to 50 μm.

9. A process according to any one of claims 1 to 8 characterised in that the organic foam has from 10 to 500 pores per linear inch (25.4 mm).

10. A process according to any one of claims 1 to 9 characterised in that the fluid slurry is an aqueous slurry.

11. A process according to any one of claims 1 to 10 characterised in that said fluid slurry contains from 10 to 80 parts by weight refractory material.

12. A process according to any one of claims 1 to 11 characterised in that the infiltrating second refractory material is applied by coating the surface of the dried impregnated foam with a dry particulate refractory material.

13. A process of claim 12 characterised in that said infiltrating particulate material has an average particle size of about 20 μm or more.

14. A process according to any one of claims 1 to 13 characterised in that the impregnating refractory material is at least one of SiC, $B_4C$, boron, $MoSi_2$, molybdenum, carbon and $TiB_2$.

15. A process according to any one of claims 1 to 14 characterised in that the infiltrating refractory material is at least one of silicon, boron, titanium and $MoSi_2$.

16. A process according to any one of claims 1 to 15 characterised in that the formed organic material is at least one organic material selected from the group consisting of cellulosics, polystyrenes, polyethylenes, polypropylenes, polyvinyl chlorides, latexes, acrylics and polyurethanes:

17. A process according to claim 16 characterised in that the organic material is polyurethane.

18. A process according to any one of claims 1 to 17 characterised in that the organic foam material is prepared by placing a sheet of foamed organic polymeric material between two heated platens, compressing the foamed material a predetermined amount between the heated platens for a predetermined time and recovering a compression heat set foamed organic polymeric material having a greater number of pores per lineal inch in the direction of its thickness than in the direction of either of its surfaces that was adjacent a platen.

19. A composite refractory foam devoid of organic polymeric material comprising a first non-oxide refractory material open cellularly and interconnectingly arranged and a second non-oxide refractory material having a lower melting point than the first refractory material and melt infiltrated into the first refractory material, obtainable by a process as claimed in any one of claims 1 to 18.

**Patentansprüche**

1. Verfahren zur Herstellung eines feuerfesten Verbundschaumes, das das Imprägnieren eines geschäumten organischen Polymermaterials mit einer flüssigen Aufschlämmung eines ersten feuerfesten Nicht-Oxidmaterials, das Trocknen des imprägnierten geschäumten Materials und das Erhitzen des imprägnierten geschäumten Materials während einer ausreichenden Zeit und einer ausreichenden Temperatur, um das organische geschäumte Material zu zersetzen und den erhaltenen Schaum frei von organischem Polymermaterial zurückzulassen, umfaßt, dadurch gekennzeichnet, daß vor dem Erhitzen ein zweites feuerfestes Nicht-Oxidmaterial auf das imprägnierte geschäumte anorganische Polymermaterial aufgebracht wird, welches zweite feuerfeste Material

a) einem niedrigeren Schmelzpunkt als das erste feuerfeste Material aufweist,

b) im geschmolzenen Zustand das erste feuerfeste Material wenn es fest ist, benetzt und

c) in bezug auf das erste feuerfeste Material eine Beständigkeit gegen Lösen des einen in das andere aufweist,

und der Erhitzungsschritt bei einer Temperatur durchgeführt wird, die ausreichend ist, das zweite feuerfeste Material zu schmelzen, aber niedriger ist als der Schmelzpunkt des Imprägnierungsmaterials, so daß das feuerfeste Imprägnierungsmaterial vom zweiten feuerfesten Material infiltriert wird.

2. Verfahren nach Anspruch 1, dadurch gekennzeichnet, daß das geschäumte organische Material vor dem Imprägnieren komprimiert wird.

3. Verfahren nach Anspruch 1 oder 2, dadurch gekennzeichnet, daß das geschäumte organische Material vor dem Imprägnieren durch Heißpressen auf ein vorherbestimmte Dicke gehärtet wird.

4. Verfahren nach Anspruch 1, 2 oder 3, dadurch gekennzeichnet, daß das geschmolzene zweite feuerfeste Material das feste feuerfeste Imprägnierungsmaterial bis zu einem Berührungswinkel von weniger als etwa 45° benetzt.

5. Verfahren nach einem der Ansprüche 1 bis 4, dadurch gekennzeichnet, daß das imprägnierte geschäumte organische Material vor dem Trocknen behandelt wird, um Flüssigkeiten auszutreiben.

6. Verfahren nach Anspruch 5, dadurch gekennzeichnet, daß dieses Material zum Austreiben von Flüssigkeiten durch Quetschen oder Walzen behandelt wird.

7. Verfahren nach einem der Ansprüche 1 bis 6, dadurch gekennzeichnet, daß der Erhitzungsschritt bei einer Temperatur von 1200 bis 2300°C durchgeführt wird.

8. Verfahren nach einem der Ansprüche 1 bis 7, dadurch gekennzeichnet, daß die Zellgröße des geschäumten organischen Materials 2500 bis 50 μm beträgt.

9. Verfahren nach einem der Ansprüche 1 bis 8, dadurch gekennzeichnet, daß der organische Schaum 10 bis 500 Poren pro linearem Zoll (25,4 mm) aufweist.

10. Verfahren nach einem der Ansprüche 1 bis 9, dadurch gekennzeichnet, daß die flüssige Aufschlämmung eines wässerige Aufschlämmung ist.

11. Verfahren nach einem der Ansprüche 1 bis 10, dadurch gekennzeichnet, daß diese flüssige Aufschlämmung 10 bis 80 Gew. Teile feuerfestes Material enthält.

12. Verfahren nach einem der Ansprüche 1 bis 11, dadurch gekennzeichnet, daß das zweite feuerfeste Infiltrationsmaterial durch Beschichten der Oberfläche des getrockneten imprägnierten Schaums mit einem trockenen teilchenförmigen feuerfesten Material aufgebracht wird.

13. Verfahren nach Anspruch 12, dadurch gekennzeichnet, daß dieses teilchenförmige Infiltrationsmaterial eine mittlere Teilchengröße von etwa 20 µm oder mehr aufweist.

14. Verfahren nach einem der Ansprüche 1 bis 13, dadurch gekennzeichnet, daß das feuerfeste Imprägnierungsmaterial mindestens eines von SiC, B$_4$C, Bor, MoSi$_2$, Molybdän, Kohlenstoff und TiB$_2$ ist.

15. Verfahren nach einem der Ansprüche 1 bis 14, dadurch gekennzeichnet, daß das feuerfeste Infiltrationsmaterial mindestens eines von Silizium, Bor, Titan und MoSi$_2$ ist.

16. Verfahren nach einem der Ansprüche 1 bis 15, dadurch gekennzeichnet, daß das geschäumte organische Material mindestens ein organisches Material ausgewählt aus der Gruppe bestehend aus Zellulosematerialien, Polystyrolen, Polyäthylenen, Polypropylenen, Polyvinylchloriden, Latices, Acrylverbindungen und Polyurethanen ist.

17. Verfahren nach Anspruch 16, dadurch gekennzeichnet, daß das organische Material Polyurethan ist.

18. Verfahren nach einem der Ansprüche 1 bis 17, dadurch gekennzeichnet, daß das organische Schaummaterial hergestellt wird, indem eine Platte von geschäumtem organischen Polymermaterial zwischen zwei Heizplatten angeordnet, das geschäumte Material zwischen den Heizplatten während einer vorherbestimmten Zeit auf ein vorherbestimmtes Ausmaß komprimiert und ein durch Heißpressen gehärtes geschäumtes organisches Polymermaterial mit einer größeren Zahl von Poren pro linearem Zoll in Richtung seiner Dicke als in Richtung jeder seiner Oberflächen, die einer Platte benachbart war, gewonnen wird.

19. Feuerfester Verbundschaum, der frei von organischem Polymermaterial ist, umfassend ein erstes feuerfestes Nicht-Oxidmaterial, das offenzellig und zusammenhängend angeordnet ist, und ein zweites feuerfestes Nicht-Oxidmaterial mit einem niedrigeren Schmelzpunkt als das erste feuerfeste Material und in das erste feuerfeste Material durch Schmelzen infiltriert, erhältlich nach einem Verfahren, wie in einem der Ansprüche 1 bis 18 beansprucht.

**Revendications**

1. Procédé pour la préparation d'une mousse réfractaire composite, comprenant l'imprégnation d'un matériau organique polymère expansé avec une suspension fluide d'un premier matériau réfractaire non oxidique, séchage du matériau expansé imprégné et chauffage du matériau expansé imprégné pendant une durée et à une température suffisantes pour décomposer la matériau expansé organique et produire une mousse exempte de matériau polymère organique, caractérisé en ce que, avant le chauffage, un second matériau réfractaire non oxidique est appliqué au matériau polymère inorganique expansé imprégné, que ce second matériau réfractaire

a) présente un point du fusion inférieur à celui du premier matériau réfractaire,

b) à l'état fondu, mouille le premier matériau réfractaire à l'état solide, et

c) par rapport au premier matériau réfractaire, présente une résistance à la solubilité de l'un dans l'autre,

et l'étape de chauffage étant effectuée à une température suffisante pour fondre le second matériau réfractaire, mais inférieure au point de fusion de matériau d'imprégnation, de sorte que le matériau réfractaire d'imprégnation est infiltré par le second matériau réfractaire.

2. Procédé selon la revendication 1, caractérisé en ce que la matériau organique expansé est compressé avant l'imprégnation.

3. Procédé selon la revendication 1 ou 2, caractérisé en ce que la matériau organique expansé est durci par compression à chaud avant l'imprégnation.

4. Procédé selon la revendication 1, 2 ou 3, caractérisé en ce que le second matériau réfractaire fondu mouille le matériau réfractaire solide d'imprégnation avec un angle de contact inférieur à environ 45 degrés.

5. Procédé selon l'une quelconque des revendications 1 à 4, caractérisé en ce que le matériau organique expansé imprégné est traité pour expulser les fluides avant le séchage.

6. Procédé selon la revendication 5, caractérisé en ce que ledit matériau est traité pour expulser les fluides par essorage ou passage entre des cylindres.

7. Procédé selon l'une quelconque des revendications 1 à 6, caractérisé en ce que l'étape de chauffage est effectuée à une température de 1200°C à 2300°C.

8. Procédé selon l'une quelconque des revendications 1 à 7, caractérisé en ce que la dimension des cellules du matériau organique expansé est de 2500 µm à 50 µm.

9. Procédé selon l'une quelconque des revendications 1 à 8, caractérisé en ce que la mousse organique comprend de 10 à 500 pores par pouce linéaire (25.4 mm).

10. Procédé selon l'une quelconque des revendications 1 à 9, caractérisé en ce que la suspension fluide est une suspension aqueuse.

11. Procédé selon l'une quelconque des revendications 1 à 10, caractérisé en ce que la suspension fluide contient de 10 à 80 parties en poids de matériau réfractaire.

12. Procédé selon l'une quelconque des revendications 1 à 11, caractérisé en ce que le second matériau réfractaire d'infiltration est appliqué par enduction de la surface de la mousse sèche imprégnée avec un matériau réfractaire particulaire sec.

13. Procédé selon la revendication 12, caractérisé en ce que ledit matériau particulaire d'infiltration présente une dimension moyenne des particules d'environ 20 μm ou plus.

14. Procédé selon l'une quelconque des revendications 1 à 13, caractérisé en ce que le matériau réfractaire d'imprégnation est au moins l'un des SiC, $B_4C$, bore, $MoSi_2$ molybdène, carbone et $TiB_2$.

15. Procédé selon l'une quelconque des revendications 1 à 14, caractérisé en ce que le matériau réfractaire d'infiltration est au moins l'un des silicium, bore, titane et $MoSi_2$.

16. Procédé selon l'une quelconque des revendications 1 à 15, caractérisé en ce que le matériau organique expansé est au moins un matériau organique choisi dans le groupe constitué par les matières cellulosiques, les polystyrènes, les polyéthylènes, les polypropylènes, les poly-(chlorures de vinyle), les latexes, les polymères acryliques et les polyuréthanes.

17. Procédé selon la revendication 16, caractérisé en ce que le matériau organique est du polyuréthane.

18. Procédé selon l'une quelconque des revendications 1 à 17, caractérisé en ce que le matériau organique expansé est préparé en plaçant une feuille de matériau polymère organique expansé entre deux plaques chauffantes, en compressant le matériau expansé dans une proportion prédéterminée entre les plaques chauffantes pendant une durée prédéterminée et en récupérant un matériau polymère organique expansé, durci par compression à chaud, ayant un plus grand nombre de pores par pouce linéaire dans le sens de l'épaisseur que dans le sens de l'une quelconque de ses faces qui était adjacente à une plaque.

19. Mousse réfractaire composite exempte de matériau polymère organique, comprenant un premier matériau réfractaire non oxydique à cellules ouvertes et agencé de manière interconnectée et un second matériau réfractaire non oxydique ayant un point de fusion inférieur à celui du premier matériau réfractaire, et infiltré à l'état fondu dans le premier matériau réfractaire, pouvant être obtenu par un procédé revendiqué dans l'une quelconque des revendications 1 à 18.